# EUROPEAN PATENT APPLICATION

(11) **EP 4 629 357 A1**
(43) Date of publication of application: **08.10.2025**
(21) Application number: 23895555.3
(22) Date of filing: 07.09.2023
(51) Int. Cl.: H01M 8/04313, H01M 8/04537, H01M 8/04664, H01M 8/249, G05F 1/67

(54) **LIFESPAN PREDICTION METHOD, LIFESPAN PREDICTION DEVICE, AND POWER GENERATION SYSTEM**

(30) Priority: 01.12.2022 JP 2022192719
(71) Applicant: Panasonic Intellectual Property Management Co., Ltd., Kadoma-shi, Osaka 571-0057 (JP)
(72) Inventor: KANEKO, Yasushi, Kadoma-shi, Osaka 571-0057 (JP); TANAKA, Yoshikazu, Kadoma-shi, Osaka 571-0057 (JP); ISE, Takehiko, Kadoma-shi, Osaka 571-0057 (JP); TAGUCHI, Yoshifumi, Kadoma-shi, Osaka 571-0057 (JP); YOSHIHARA, Yasumichi, Kadoma-shi, Osaka 571-0057 (JP)
(74) Representative: Grünecker Patent- und Rechtsanwälte PartG mbB
(86) International application number: PCT/JP2023/032599
(87) International publication number: WO 2024/116527

(57) **Abstract**

A life prediction method according to the present disclosure is a life prediction method for a field cell apparatus including power generation units each including a fuel cell. The life prediction method includes predicting a time when each of the power generation units of the fuel cell apparatus reaches an end of life, from a cumulative power generation time of the power generation unit of the fuel cell apparatus at which the power generation unit is determined to reach the end of life, and from a ratio of a number of the power generation units that generate power out of a total number of the power generation units of the fuel cell apparatus in a predetermined period.

## Description

### Technical Field

The present disclosure relates to a life prediction method, a life prediction apparatus, and a power generation system.

### Background Art

Various proposals have hitherto been made with respect to the life prediction for power generation systems. In one example, PTL 1 discloses a life prediction method for a fuel cell. The life prediction method includes: measuring a rate of change in voltage of a fuel cell operated in accordance with a basic operation pattern (step S1); approximating, by a predetermined approximate expression, the relationship between the rate of change in voltage and the power generation time with respect to the basic operation pattern (step S2); by using the approximate expression, determining the amount of decrease in voltage of the fuel cell (step S3); and in response to the amount of decrease in voltage exceeding a predetermined value, determining that the life of the fuel cell has ended (step S4).

### Citation List

### Patent Literature

PTL 1: Japanese Unexamined Patent Application Publication NO. 11-97049

### Summary of Invention

### Technical Problem

In one example, the present disclosure provides a life prediction method, a life prediction apparatus, and a power generation system that make it possible to predict, with higher accuracy than in the related art, the time when each of power generation units belonging to a power generation group and including a fuel cell reaches the end of life. Solution to Problem

To address the problem mentioned above, an aspect of the present disclosure provides a life prediction method for a fuel cell apparatus including power generation units. The power generation units each include a fuel cell. The life prediction method includes predicting a time when each of the power generation units of the fuel cell apparatus reaches an end of life, from a cumulative power generation time of the power generation unit of the fuel cell apparatus at which the power generation unit is determined to reach the end of life, and from a ratio of a number of the power generation units that generate power out of a total number of the power generation units of the fuel cell apparatus in a predetermined period.

An aspect of the present disclosure provides a life prediction apparatus for a fuel cell apparatus including power generation units. The power generation units each include a fuel cell. The life prediction apparatus includes a controller, and a communicator. The controller predicts a time when each of the power generation units of the fuel cell apparatus reaches an end of life, from a cumulative power generation time of the power generation unit of the fuel cell apparatus at which the power generation unit is determined to reach the end of life, and from a ratio of a number of the power generation units that generate power out of a total number of the power generation units of the fuel cell apparatus in a predetermined period. The communicator communicates information to a display. The information indicates the predicted time when the power generation unit of the fuel cell apparatus reaches the end of life.

An aspect of the present disclosure provides a power generation system including power generation units, and the life prediction apparatus mentioned above. The power generation units each include a fuel cell.

### Advantageous Effects of Invention

The life prediction method, the life prediction apparatus, and the power generation system according to an aspect of the present disclosure make it possible to predict, with higher accuracy than in the related art, the time when each of power generation units belonging to a power generation group and including a fuel cell reaches the end of life.

### Brief Description of Drawings

[Fig. 1] Fig. 1 illustrates an example of a power generation system according to an embodiment.
[Fig. 2] Fig. 2 illustrates an example of a life prediction apparatus illustrated in Fig. 1.
[Fig. 3] Fig. 3 is a flowchart according to the embodiment, illustrating an example of an operation (method for predicting the life of each of power generation units of a fuel cell apparatus) of the life prediction apparatus in the power generation system.
[Fig. 4] Fig. 4 is a flowchart according to Example 1 of the embodiment, illustrating an example of an operation (method for predicting the life of each of power generation units of the fuel cell apparatus) of the life prediction apparatus in the power generation system.
[Fig. 5] Fig. 5 is a flowchart according to Example 2 of the embodiment, illustrating an example of an operation (method for predicting the life of each of power generation units of the fuel cell apparatus) of the life prediction apparatus in the power generation system.
[Fig. 6] Fig. 6 illustrates an example of a voltage stabilization timing when voltage becomes stable after the elapse of a predetermined time from the start of power generation by a power generation unit.
[Fig. 7] Fig. 7 illustrates, for explanatory purposes, an example of an approximation line representing the correlation between the cumulative power generation time of a power generation unit and its voltage.
[Fig. 8] Fig. 8 illustrates an example of a power generation plan for the power generation system according to Example 3 of the embodiment, for explaining an example of a method for determining a ratio R1 of the number of power generation units that generate power out of the total number of power generation units in a predetermined period.

### Description of Embodiments

PTL 1 does not consider predicting the time when multiple power generation units each reach the end of life. Specifically, in PTL 1, the operating ratio of a fuel cell apparatus including multiple power generation units is not taken into account. This makes it difficult to accurately predict the time when each of the power generation units reaches the end of life.

Accordingly, a first aspect of the present disclosure provides a life prediction method for a fuel cell apparatus including power generation units. The power generation units each include a fuel cell. The life prediction method includes predicting a time when each of the power generation units of the fuel cell apparatus reaches an end of life, from a cumulative power generation time of the power generation unit of the fuel cell apparatus at which the power generation unit is determined to reach the end of life, and from a ratio of a number of the power generation units that generate power out of a total number of the power generation units of the fuel cell apparatus in a predetermined period.

The life prediction method according to the first aspect mentioned above makes it possible to predict, with higher accuracy than in the related art, the time when each of power generation units belonging to a power generation group and including a fuel cell reaches the end of life.

Specifically, the ratio of the number of power generation units that generate power out of the total number of power generation units of the fuel cell apparatus in the predetermined period corresponds to the number-based operating ratio of the fuel cell apparatus. In other words, the number-based operating ratio of the fuel cell apparatus corresponds to the ratio of the number of power generation units that generate power out of the total number of power generation units when the fuel cell apparatus generates power in the predetermined period.

In this regard, if each of the power generation units is used substantially evenly in the predetermined period, the number-based operating ratio of the fuel cell apparatus and the capacity utilization ratio of each of the power generation units are substantially equal. The higher the capacity utilization ratio of a power generation unit, the faster the rate of degradation of the power generation unit. That is, a negative correlation exists between the ratio mentioned above and the life of the power generation unit.

As described above, the life prediction method according to the first aspect takes the ratio mentioned above into account in predicting the time when each of the power generation units that includes a fuel cell reaches the end of life. This allows for accurate prediction of the time when each of the power generation units reaches the end of life, in comparison to a case where the ratio mentioned above is not taken into account.

According to a second aspect of the present disclosure, in the life prediction method according to the first aspect, the cumulative power generation time of the power generation unit of the fuel cell apparatus at which the power generation unit is determined to reach the end of life may be calculated based on a prediction of a decrease in voltage due to degradation of the power generation unit of the fuel cell apparatus.

A power generation unit is generally known to decrease in voltage due to degradation of the power generation unit as the cumulative power generation time of the power generation unit increases.

Accordingly, with the life prediction method according to the second aspect, for example, it is predicted, from the progression of a voltage (actual measurement data) with respect to the cumulative power generation time of each power generation unit, how the value of the voltage will decrease with the passage of the cumulative power generation time in the future. Then, the cumulative power generation time at which the predicted value of the voltage reaches a predetermined end-of-life threshold voltage can be calculated appropriately as the cumulative power generation time at which the power generation unit is determined to reach the end of life.

According to a third aspect of the present disclosure, in the life prediction method according to the first aspect or the second aspect, the predetermined time may include time slots, and the ratio may be calculated as a first value divided by a second value. The first value is a summation, over the predetermined period, of a number of the power generation units that generate power in each of the time slots. The second value is the total number of the power generation units multiplied by a total number of the time slots included in the predetermined period.

With the life prediction method according to the third aspect mentioned above, the number-based operating ratio of the fuel cell apparatus in the predetermined period can be calculated from the following values: the summation of the number of power generation units that are "required to generate power" in each of the time slots; and the summation of the total number of power generation units in each of the time slots.

A fourth aspect of the present disclosure provides a life prediction apparatus for a fuel cell apparatus including power generation units. The power generation units each include a fuel cell. The life prediction apparatus includes a controller, and a communicator. The controller predicts a time when each of the power generation units of the fuel cell apparatus reaches an end of life, from a cumulative power generation time of the power generation unit of the fuel cell apparatus at which the power generation unit is determined to reach the end of life, and from a ratio of a number of the power generation units that generate power out of a total number of the power generation units of the fuel cell apparatus in a predetermined period. The communicator communicates information to a display. The information indicates the predicted time when the power generation unit of the fuel cell apparatus reaches the end of life.

The life prediction apparatus according to the fourth aspect configured as described above makes it possible to predict, with higher accuracy than in the related art, the time when each of power generation units belonging to a power generation group and including a fuel cell reaches the end of life. Details of an operational effect provided by the life prediction apparatus according to the fourth aspect will not be described below as the operational effect is substantially the same as the operational effect provided by the life prediction method according to the first aspect.

A fifth aspect of the present disclosure provides a power generation system including a fuel cell apparatus, and the life prediction apparatus according to the fourth aspect. The field cell apparatus includes power generation units. The power generation units each include a fuel cell.

The configuration mentioned above makes it possible to predict, with higher accuracy than in the related art, the time when each of power generation units belonging to a power generation group and including a fuel cell reaches the end of life. Details of an operational effect provided by the power generation system according to the fifth aspect will not be described below as the operational effect is substantially the same as the operational effect provided by the life prediction method according to the first aspect.

Specific examples of the above-mentioned aspects of the present disclosure will now be described with reference to the attached drawings. The specific examples described below each represent one example of the above-mentioned aspects of the present disclosure. Specific details set forth in the following description, such as shapes, numeric values, constituent elements, and the positioning and connection of constituent elements, are not intended to limit the scope of the claims unless specifically recited in the claims.

Those constituent elements in the following description which are not cited in the independent claim representing the most generic concept of the present disclosure will be described as optional constituent elements. In the drawings, descriptions of features designated by the same reference signs will be sometimes omitted. For ease of understanding, the drawings schematically depict individual constituent elements, and are sometimes not accurate representations as to their shapes, dimensional ratios, or other details.

Further, as for apparatus operation, as required, the order of steps may be rearranged, or a known step may be added.

### (Embodiment)

### [Apparatus Configuration]

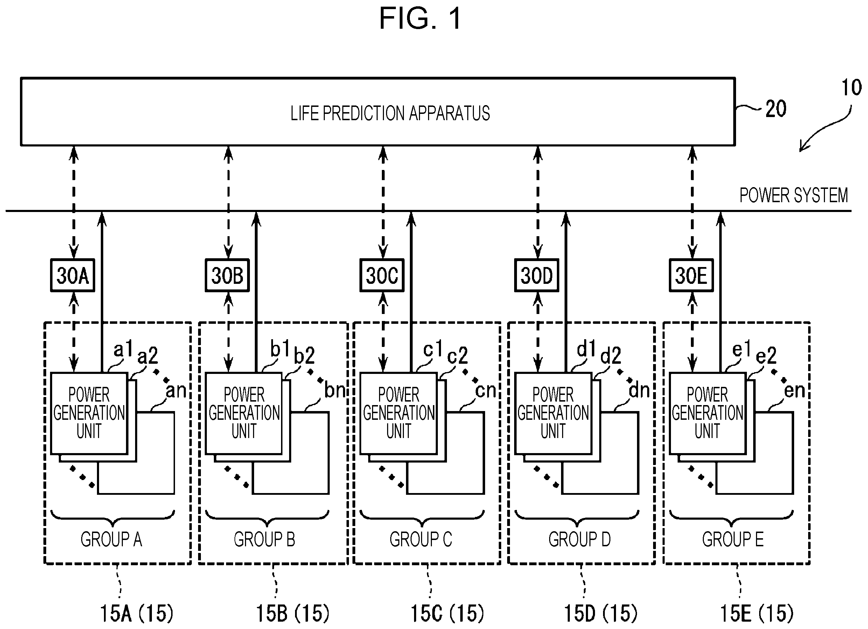

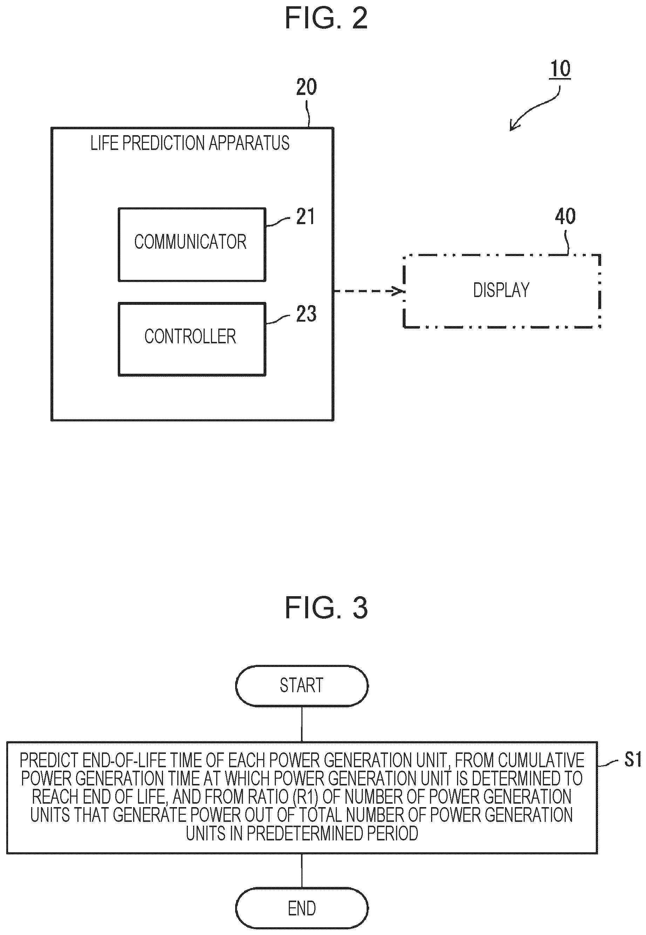

Fig. 1 illustrates an example of a power generation system according to an embodiment. Fig. 2 illustrates an example of a life prediction apparatus illustrated in Fig. 1.

A power generation system 10 according to the embodiment includes a fuel cell apparatus 15, and a life prediction apparatus 20. The fuel cell apparatus 15 includes power generation units each including a fuel cell. As illustrated in Fig. 1, the power generation system 10 includes power generation units grouped into the following groups of power generation units each including a fuel cell: power generation units a1 to an, b1 to bn, c1 to cn, d1 to dn, and e1 to en. The power generation system 10 may be, for example a system that supplies bulk power to a power system. The configuration of the fuel cell apparatus 15 in Fig. 1 will now be described in more detail.

The power generation units are grouped into the power generation units a1 to an, b1 to bn, c1 to cn, d1 to dn, and e1 to en. Although not illustrated, the power generation units a1 to an, b1 to bn, c1 to cn, d1 to dn, and e1 to en each include components such as a fuel cell stack, a power conditioner, and a control device. The power conditioner serves to convert direct-current power generated by the fuel cell stack into alternating-current power for output to the power system. The control device controls operation of the fuel cell stack and the power conditioner.

In the present example, the power generation units are grouped into the following groups: the power generation units a1 to an belonging to a fuel cell apparatus 15A; the power generation units b1 to bn belonging to a fuel cell apparatus 15B; the power generation units c1 to cn belonging to a fuel cell apparatus 15C; the power generation units d1 to dn belonging to a fuel cell apparatus 15D; and the power generation units e1 to en belonging to a fuel cell apparatus 15E. All power generation units belonging to one group are also referred to simply as "power generation units within a group." Hereinafter, for convenience of explanation, the power generation units a1 to an, b1 to bn, c1 to cn, d1 to dn, and e1 to en will be sometimes abbreviated as "power generation units 15ij (i = a to e, j = 1 to n)."

The configuration of the fuel cell apparatus 15 mentioned above is, however, intended to be illustrative and not limiting. For example, the fuel cell apparatus 15 may be grouped based on power generation units within a single group.

Control devices 30A to 30E are provided respectively for a group A, a group B, a group C, a group D, and a group E, in other words, for the fuel cell apparatuses 15A to 15E. The control devices 30A to 30E each control operation of each individual power generation unit within the corresponding group.

For example, the control device 30A controls, via a communication network, the output of each of the power generation units a1 to an belonging to the group A so as to allow efficient operation (e.g., life optimization) of the power generation units a1 to an. In one configuration, each power generation unit may include no control device, and the operation of power generation units belonging to individual groups may be controlled directly by the control devices 30A to 30E.

The control devices 30A to 30E may be any devices with a control capability. The control devices 30A to 30E each include a processing section (not illustrated), a storage section (not illustrated) that stores a control program, and a communicator (not illustrated). As the processing section reads and executes the control program stored in the storage section, a predetermined control is executed in each of the control devices 30A to 30E. An example of the processing section is a microprocessor. An example of the storage section is a memory.

The life prediction apparatus 20 predicts the life of each individual power generation unit included in the fuel cell apparatus 15. As illustrated in Fig. 2, the life prediction apparatus 20 includes a communicator 21, and a controller 23.

The controller 23 predicts the time when each of the power generation units 15ij (i = a to e, j = 1 to n) reaches the end of life (hereinafter, "end-of-life time") from the following values: the cumulative power generation time at which each of the power generation units 15ij (i = a to e, j = 1 to n) is determined to reach the end of life; and a ratio R1 of the number of power generation units that generate power out of the total number of power generation units in a predetermined period.

The meaning of the above-mentioned expression "the number of power generation units that generate power out of the total number of power generation units" may include not only fuel cell units that are determined as being "required to generate power" in a power generation plan stored in a storage section of the controller 23, but also fuel cell units that have actually generated power.

The "predetermined period" mentioned above may be the entire period of the power generation plan stored in the storage section of the controller 23, or may be part of the entire period. Although the term "predetermined period" may mean, for example, a period of about one to several days, the term may also mean a suitable period with a longer duration ranging from one week (seven days) to one month.

As for the "cumulative power generation time at which each of the power generation units is determined to reach the end of life" and the "ratio R1 of the number of power generation units that generate power out of the total number of power generation units in a predetermined period", their respective specific examples will be described later in the description of Examples.

The communicator 21 is a transmitter that communicates, to a display 40, information indicating the predicted end-of-life time of each of the power generation units 15ij (i = a to e, j = 1 to n) of the fuel cell apparatus 15. The information may be, for example, a year/month/day on a calendar displayed on the display 40. Examples of the "display 40" may include, but are not limited to, an information terminal of a service consumer who receives the supply of power generated by the power generation system 10, and a display device of a maintenance company. Accordingly, for example, a service consumer who receives the supply of power generated by the power generation system 10 can easily learn how much life each of the power generation units 15ij (i = a to e, j = 1 to n) has.

In the present example, the controller 23 predicts the end-of-life time for each of the power generation units 15ij (i = a to e, j = 1 to n). This, however, is not intended to be limiting.

In another alternative example, control devices (e.g., the control devices 30A to 30E) other than the controller 23 may predict the end-of-life time for each of the power generation units 15ij (i = a to e, j = 1 to n).

In another alternative example, control devices (e.g., control devices (not illustrated) within individual power generation units) other than the controller 23 and the control devices 30A to 30E may predict the end-of-life time for each of the power generation units 15ij (i = a to e, j = 1 to n).

The controller 23 may be any component with a control capability. The controller 23 includes a processing section (not illustrated), and a storage section (not illustrated) that stores a control program. As the processing section reads and executes the control program stored in the storage section, a predetermined control is executed in the controller 23. An example of the processing section is a microprocessor. An example of the storage section is a memory.

The configuration of the power generation system 10 mentioned above is, however, intended to be illustrative and not limiting. For example, the life prediction apparatus 20 may be integrated with the control devices 30A to 30E, in other words, the life prediction apparatus 20 may incorporate the control capability of the control devices 30A to 30E to directly control the operation of each of power generation units within the corresponding groups.

### [Operation]

Fig. 3 is a flowchart according to the embodiment, illustrating an example of an operation (method for predicting the life of each power generation unit of the fuel cell apparatus) of the life prediction apparatus in the power generation system. The operation described below may be performed by, for example, the processing section of the controller 23 reading the control program from the storage section of the controller 23. However, the operation described below does not necessarily need to be performed by the controller 23. An operator may perform part of the operation. The example described below is directed to a case where the operation is controlled by the controller 23.

When operation of the life prediction apparatus 20 starts, then at step S1, the end-of-life time of each of the power generation units 15ij (i = a to e, j = 1 to n) of the fuel cell apparatus 15 is predicted from the following values: the cumulative power generation time at which each of the power generation units 15ij (i = a to e, j = 1 to n) is determined to reach the end of life; and the ratio R1 of the number of power generation units that generate power out of the total number of power generation units in a predetermined period.

Specifically, based on the ratio R1, it is estimated how much the cumulative power generation time of each of the power generation units 15ij (i = a to e, j = 1 to n) of the fuel cell apparatus 15 will increase relative to how much the cumulative power generation time of the fuel cell apparatus 15 will increase in the future, and then it is predicted when the cumulative power generation time determined to be the end of life is reached.

In the above prediction, a time-based operating ratio R2, which represents the ratio of the operating time of the fuel cell apparatus 15 in a predetermined period, may be taken into account. The time-based operating ratio R2 will be described later in detail with reference to Example 1.

For each of the power generation units 15ij (i = a to e, j = 1 to n), the operation at step S1 may be repeated every time the cumulative power generation time increases by a predetermined amount. Information indicating the predicted end-of-life time of each of the power generation units 15ij (i = a to e, j = 1 to n) may be communicated to the display 40 (see Fig. 2). The information may be displayed as, for example, a year/month/day on a calendar on the display 40.

The embodiment as described in the foregoing makes it possible to predict, with higher accuracy than in the related art, the time when each of the power generation units 15ij (i = a to e, j = 1 to n) included in the corresponding fuel cell apparatuses 15A to 15E reaches the end of life.

Specifically, the ratio R1, which represents the ratio of the number of power generation units that generate power out of the total number of power generation units of the fuel cell apparatus 15 in the predetermined period, corresponds to the number-based operating ratio of the fuel cell apparatus 15. In this regard, if each of the power generation units 15ij (i = a to e, j = 1 to n) is used substantially evenly in the predetermined period, the number-based operating ratio of the fuel cell apparatus 15 and the capacity utilization ratio of each of the power generation units 15ij (i = a to e, j = 1 to n) are substantially equal. The higher the capacity utilization ratio of a power generation unit, the faster the rate of degradation of the power generation unit. That is, a negative correlation exists between the ratio R1 and the life of the power generation unit.

As described above, according to the embodiment, the ratio R1 is taken into account in predicting the time when each of the power generation units 15ij (i = a to e, j = 1 to n) that includes a fuel cell reaches the end of life. This allows for accurate prediction of the time when each of the power generation units 15ij (i = a to e, j = 1 to n) reaches the end of life, in comparison to a case where the ratio R1 is not taken into account.

### (Example 1)

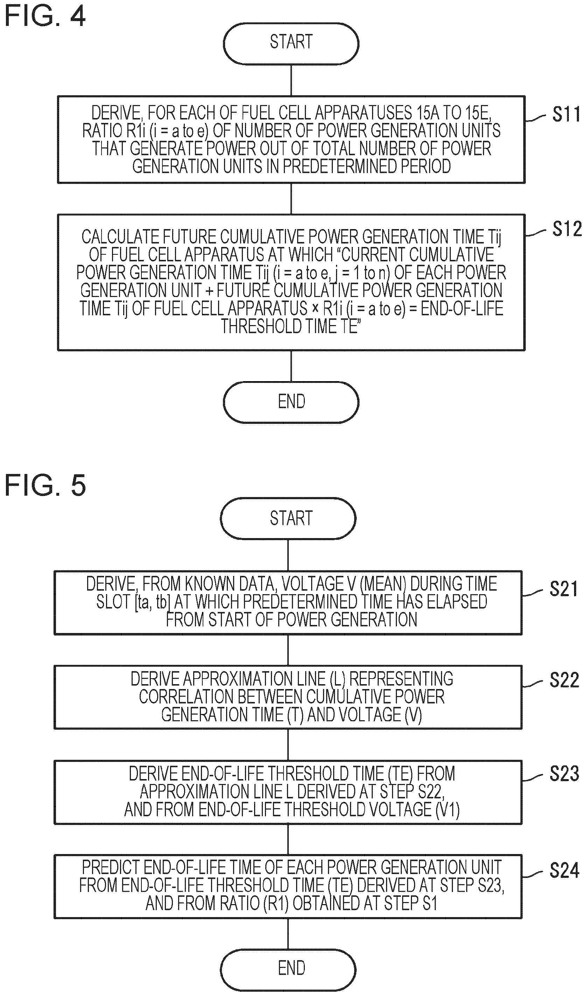

Fig. 4 is a flowchart according to Example 1 of the embodiment, illustrating an example of an operation (method for predicting the life of each of power generation units of the fuel cell apparatus) of the life prediction apparatus in the power generation system. The operation described below may be performed by, for example, the processing section of the controller 23 reading the control program from the storage section of the controller 23. However, the operation described below does not necessarily need to be performed by the controller 23. An operator may perform part of the operation. The example described below is directed to a case where the operation is controlled by the controller 23.

When operation of the life prediction apparatus 20 starts, then at step S11, a ratio R1i (i = a to e) is derived for each of the fuel cell apparatuses 15A to 15E. The ratio R1i is the ratio of the number of power generation units that generate power out of the total number of power generation units in a predetermined period.

Subsequently, from the ratio R1i (i = a to e) derived at step S11, it is estimated how much the cumulative power generation time of each of the power generation units 15ij (i = a to e, j = 1 to n) will increase relative to how much the cumulative power generation time of the fuel cell apparatus 15 will increase in the future. Specifically, the future cumulative power generation time of each of the power generation units 15ij (i = a to e, j = 1 to n) is estimated as "the future cumulative power generation time Tij (i = a to e, j = 1 to n) of the fuel cell apparatus 15 × the ratio R1." This is explained below with respect to, for example, the ratio R1a for the fuel cell apparatus 15A. If the ratio R1a is 0.5, then the future cumulative power generation time of each of the power generation units 15aj (j = 1 to n) is estimated to be 0.5 times the future cumulative power generation time Ta of the fuel cell apparatus 15A.

Then, at step S12, the following value is calculated: the future cumulative power generation time Tij (i = a to e, j = 1 to n) of the fuel cell apparatus 15 at which the current cumulative power generation time Tij (i = a to e, j = 1 to n) of each of the power generation units 15ij (i = a to e, j = 1 to n) plus "the future cumulative power generation time Tij (i = a to e, j = 1 to n) of the fuel cell apparatus 15 × the ratio R1i (i = a to e)" becomes equal to the cumulative power generation time (end-of-life threshold time TE) at which the end of life is determined to be reached. From the calculated value of the future cumulative power generation time Tij (i = a to e, j = 1 to n), the end-of-life time of each of the power generation units 15ij (i = a to e, j = 1 to n) is predicted.

For each of the power generation units 15ij (i = a to e, j = 1 to n), the operations at steps S11 and S12 may be repeated every time the cumulative power generation time increases by a predetermined amount. Information indicating the predicted end-of-life time of each of the power generation units 15ij (i = a to e, j = 1 to n) may be communicated to the display 40 (see Fig. 2). The information may be displayed as, for example, a year/month/day on a calendar on the display 40.

The life prediction method for the fuel cell apparatus 15 described in the foregoing is, however, intended to be illustrative and not limiting.

For example, assuming that in a predetermined period, the fuel cell apparatus 15 is continuously performing power generation, and expected to continue to perform power generation in a similar manner with no interruption of power generation, then the future cumulative power generation time Tij (i = a to e, j = 1 to n) calculated in the above-mentioned example, that is, the future cumulative power generation time of the fuel cell apparatus 15 at which the end-of-life threshold time TE is reached, is used directly in predicting the end-of-life time of each of the power generation units 15ij (i = a to e, j = 1 to n).

However, if the predetermined period includes a period during which the fuel cell apparatus 15 stops power generation, a time-based operating ratio R2i (i = a to e) of the fuel cell apparatus 15 may be taken into account in predicting the life of each of the power generation units 15ij (i = a to e, j = 1 to n). The "time-based operating ratio R2i (i = a to e)" corresponds to the ratio of the time for which each of the fuel cell apparatuses 15A to 15E performs power generation (operates) in the predetermined period. In other words, the time-based operating ratio R2i (i = a to e) corresponds to the ratio of the time for which at least one of power generation units included in each of the fuel cell apparatuses 15A to 15E performs power generation in the predetermined period.

This is explained below with respect to, for example, the time-based operating ratio R2a of the fuel cell apparatus 15A. If a predetermined period in a power generation plan stored in the storage section of the controller 23 is one month, then the time-based operating ratio R2a is calculated based on the following pieces of data: how many hours per day the fuel cell apparatus 15A performs power generation; and how many days per month the fuel cell apparatus 15A performs power generation. In one example, if the fuel cell apparatus 15A performs power generation for only a half-day per day, and does not perform power generation on weekends, then the time-based operating ratio R2a of the fuel cell apparatus 15A is calculated to be about 0.37 (= 0.5 × 22/30).

Subsequently, the end-of-life time of each of the power generation units 15aj (j = 1 to n) is predicted by calculating the following value: "the future cumulative power generation time Taj (j = 1 to n) of the fuel cell apparatus 15 at which the end-of-life threshold time TE is reached / R2a." Specifically, the end-of-life time of each of the power generation units 15aj (j = 1 to n) is predicted from a value obtained by multiplying, by a factor of about 2.7, the future cumulative power generation time Taj (j = 1 to n) of the fuel cell apparatus 15A at which the end-of-life threshold time TE is reached.

### (Example 2)

A life prediction method according to Example 2 of the embodiment is substantially the same as the life prediction method according to the embodiment, except for that the cumulative power generation time at which each of the power generation units 15ij (i = a to e, j = 1 to n) is determined to reach the end of life is calculated based on the prediction of a decrease in voltage due to degradation of each of the power generation units 15ij (i = a to e, j = 1 to n) of the fuel cell apparatus 15.

Fig. 5 is a flowchart according to Example 2 of the embodiment, illustrating an example of an operation (method for predicting the life of each of power generation units of the fuel cell apparatus) of the life prediction apparatus in the power generation system. The operation described below may be performed by, for example, the processing section of the controller 23 reading the control program from the storage section of the controller 23. However, the operation described below does not necessarily need to be performed by the controller 23. An operator may perform part of the operation. The example described below is directed to a case where the operation is controlled by the controller 23.

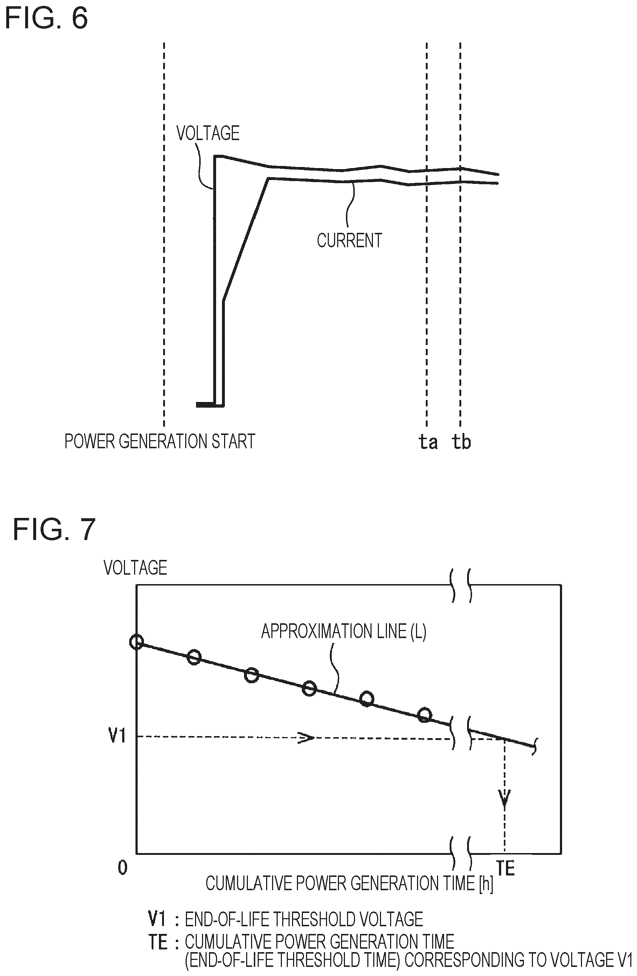

First, at step S21, a voltage V is derived from known data. The voltage V is the voltage during a time slot [ta, tb] from time instant ta to time instant tb, which is a slot of time when a predetermined time has elapsed from the start of power generation by each of the power generation units 15ij (i = a to e, j = 1 to n). As illustrated in Fig. 6, the time slot [ta, tb] corresponds to a suitable voltage stabilization timing when the voltage stabilizes after the elapse of a predetermined time from the start of power generation at rated operation. Accordingly, the voltage V may be the mean voltage during the time slot [ta, tb]. In one non-limiting example, the time from time instant ta to time instant tb may be about 30 minutes. The "known data" refers to the voltage at a voltage stabilization timing following the start of power generation at a suitable time between when the power generation time of each of the power generation units 15ij (i = a to e, j = 1 to n) is "zero", and the current cumulative power generation time. The known data is stored in the storage section of the power generation system 10.

Subsequently, at step S22, an approximation line L is derived. The approximation line L represents the correlation between the cumulative power generation time T of each of the power generation units 15ij (i = a to e, j = 1 to n), and the voltage V. Specifically, a power generation unit is generally known to decrease in voltage due to degradation of the power generation unit as the cumulative power generation time T of the power generation unit increases. Accordingly, the approximation line L can be obtained based on the values of the voltage V (known data) represented by circles in Fig. 7.

Subsequently, at step S23, the cumulative power generation time at which each of the power generation units 15ij (i = a to e, j = 1 to n) is determined to reach the end of life (hereinafter, "end-of-life threshold time TE") is derived from the approximation line L derived at step S22, and from an end-of-life threshold voltage V1 of the power generation unit. Specifically, since the end-of-life threshold voltage V1 is a value determined in advance for the power generation system 10, the end-of-life threshold time TE can be found from the approximation line L and the end-of-life threshold voltage V1 as illustrated in Fig. 7.

Subsequently, at step S24, the end-of-life time of each of the power generation units 15ij (i = a to e, j = 1 to n) is predicted from the end-of-life threshold time TE derived at step S23, and from the ratio R1 obtained at step S1 in Fig. 3.

For each of the power generation units 15ij (i = a to e, j = 1 to n), the operations at steps S21 to S24 may be repeated every time the cumulative power generation time T increases by a predetermined amount. Information indicating the predicted end-of-life time of each of the power generation units 15ij (i = a to e, j = 1 to n) may be communicated to the display 40 (see Fig. 2). The information may be displayed as, for example, a year/month/day on a calendar on the display 40.

As described above, with the life prediction method according to Example 2, for example, it is predicted, from the progression of the voltage V (actual measurement data) with respect to the cumulative power generation time of each of the power generation units 15ij (i = a to e, j = 1 to n), how the value of the voltage V will decrease with the passage of the cumulative power generation time in the future. Then, the cumulative power generation time at which the predicted value of the voltage V reaches the predetermined end-of-life threshold voltage V1 can be calculated appropriately as the cumulative power generation time (the end-of-life threshold time TE) at which each of the power generation units 15ij (i = a to e, j = 1 to n) is determined to reach the end of life.

The life prediction method, the life prediction apparatus 20, and the power generation system 10 according to Example 2 may be substantially the same as those according to the embodiment or Example 1 of the embodiment, except for the characteristic features mentioned above.

### (Example 3)

A life prediction method according to Example 2 of the embodiment is substantially the same as the life prediction method according to the embodiment, except for that the predetermined period includes time slots TS, and that the ratio R1 is calculated by dividing a first value by a second value, the first value being the summation, over the predetermined period, of the number of power generation units that generate power in each of the time slots TS, the second value being the total number of power generation units multiplied by the total number of the time slots TS included in a predetermined period.

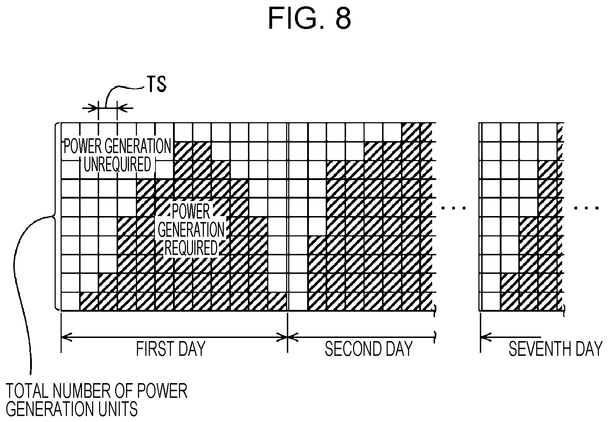

Fig. 8 illustrates an example of a power generation plan for the power generation system according to Example 2 of the embodiment, for explaining an example of a method for determining the ratio R1 of the number of power generation units that generate power out of the total number of power generation units in a predetermined period.

Fig. 8 illustrates, for each of the first day, a portion of the second day, and a portion of the seventh day for a case where the predetermined period in the power generation plan stored in the storage section of the controller 23 is one week, a subset of power generation units determined as being required to generate power (hatched areas in Fig. 8), and a subset of power generation units determined as not being required to generate power (blank areas in Fig. 8).

As illustrated in Fig. 8, the predetermined period in the power generation plan includes the time slots TS. In one example, the duration of each time slot TS may be, but is not limited to, about several tens of minutes to several hours.

The number-based operating ratio (the ratio R1) of the fuel cell apparatus 15 corresponds to the ratio of the sum total of the number of power generation units determined as being "required to generate power" in each of the time slots TS in the predetermined period in the power generation plan, to the sum total of the number of power generation units that are "required to generate power" in each of the time slots TS assuming that all of the power generation units of the fuel cell apparatus 15 are "required to generate power" in all of the time slots in the predetermined period in the power generation plan.

That is, with the life prediction method according to Example 3, the number-based operating ratio (ratio R1) of the fuel cell apparatus 15 can be calculated from the following values: the summation of the number of power generation units that are "required to generate power" in each of the time slots TS; and the summation of the total number of power generation units in each of the time slots TS.

Now, assuming that all of power generation units determined as being "required to generate power" generate power at rated operation over the predetermined period in the power generation plan, the number-based operating ratio (ratio R1) of the fuel cell apparatus 15 can be also calculated as described below based on the amount of power generation according to the power generation plan.

That is, the number-based operating ratio (ratio R1) of the fuel cell apparatus 15 in this case corresponds to the ratio of the total amount of power generated by power generation units determined as being "required to generate power", to the total amount of power generated assuming that all of the power generation units of the fuel cell apparatus 15 are "required to generated power" in all of the time slots in the predetermined period in the power generation plan.

The exemplary configuration mentioned above is intended to be illustrative and not limiting. For example, the foregoing description is directed to the case where the number-based operating ratio (the ratio R1) of the fuel cell apparatus 15 is calculated by using the number of power generation units that are determined as being "required to generate power" in the power generation plan stored in the storage section of the controller 23. Alternatively, for example, the ratio R1 may be calculated by using the number of fuel cell units that have actually generated power. Further, the predetermined period in the power generation plan is not limited to one week.

The life prediction method, the life prediction apparatus 20, and the power generation system 10 according to Example 3 may be substantially the same as those according to any one of the embodiment and Examples 1 and 2 of the embodiment, except for the characteristic features mentioned above.

The embodiment, and Examples 1 to 3 of the embodiment may be combined with each other as long as no conflict occurs therebetween. From the foregoing description, numerous improvements and other embodiments of the present disclosure would be apparent to persons skilled in the art. Therefore, the foregoing description should be construed as illustrative only, and has been provided for the purpose of teaching persons skilled in the art the best modes for carrying out the present disclosure. Details of the structure and/or function according to the present disclosure can be changed substantially without departing from the spirit of the present disclosure.

### Industrial Applicability

An aspect of the present disclosure is applicable to a life prediction method, a life prediction apparatus, and a power generation system that make it possible to predict, with higher accuracy than in the related art, the time when each of power generation units belonging to a power generation group and including a fuel cell reaches the end of life. Reference Signs List

10: power generation system
15: fuel cell apparatus
15A: fuel cell apparatus
15B: fuel cell apparatus
15C: fuel cell apparatus
15D: fuel cell apparatus
15E: fuel cell apparatus
20: life prediction apparatus
21: communicator
23: controller
30A: control device
30B: control device
30C: control device
30D: control device
30E: control device
40: display
a1 to an: power generation unit
b1 to bn: power generation unit
c1 to cn: power generation unit
d1 to dn: power generation unit
e1 to en: power generation unit

## Claims

1. A life prediction method for a fuel cell apparatus including power generation units, the power generation units each including a fuel cell, the life prediction method comprising:
predicting a time when each of the power generation units of the fuel cell apparatus reaches an end of life, from a cumulative power generation time of the power generation unit of the fuel cell apparatus at which the power generation unit is determined to reach the end of life, and from a ratio of the power generation units that generate power out of the power generation units of the fuel cell apparatus in a predetermined period.

2. The life prediction method according to claim 1, wherein the cumulative power generation time of the power generation unit of the fuel cell apparatus at which the power generation unit is determined to reach the end of life is calculated based on a prediction of a decrease in voltage due to degradation of the power generation unit of the fuel cell apparatus.

3. The life prediction method according to claim 1 or 2,
wherein the predetermined time includes time slots, and
wherein the ratio is calculated as a first value divided by a second value, the first value being a summation, over the predetermined period, of a number of the power generation units that generate power in each of the time slots, the second value being the total number of the power generation units multiplied by a total number of the time slots included in the predetermined period.

4. A life prediction apparatus for a fuel cell apparatus including power generation units, the power generation units each including a fuel cell, the life prediction apparatus comprising:
a controller that predicts a time when each of the power generation units of the fuel cell apparatus reaches an end of life, from a cumulative power generation time of the power generation unit of the fuel cell apparatus at which the power generation unit is determined to reach the end of life, and from a number of the power generation units that generate power out of the power generation units of the fuel cell apparatus in a predetermined period; and
a communicator that communicates information to a display, the information indicating the predicted time when the power generation unit of the fuel cell apparatus reaches the end of life.

5. A power generation system comprising:
a fuel cell apparatus including power generation units, the power generation units each including a fuel cell; and
the life prediction apparatus according to claim 4.
